(19) Europäisches Patentamt
European Patent Office
Office européen des brevets

(11) Numéro de publication : **0 236 158 B1**

# (12) FASCICULE DE BREVET EUROPEEN

(45) Date de publication du fascicule du brevet : **27.03.91 Bulletin 91/13**

(51) Int. Cl.⁵ : **F02P 3/04,** H03K 17/08, G05F 1/56

(21) Numéro de dépôt : **87400101.9**

(22) Date de dépôt : **16.01.87**

(54) **Régulateur de tension.**

(30) Priorité : **24.01.86 FR 8601045**

(43) Date de publication de la demande : **09.09.87 Bulletin 87/37**

(45) Mention de la délivrance du brevet : **27.03.91 Bulletin 91/13**

(84) Etats contractants désignés : **DE GB IT**

(56) Documents cités :
**GB-A- 2 060 770**
**GB-A- 2 100 086**
**US-A- 3 882 840**
**US-A- 4 514 648**

(73) Titulaire : **AUTOMOBILES PEUGEOT**
**75, avenue de la Grande Armée**
**F-75116 Paris (FR)**
Titulaire : **AUTOMOBILES CITROEN**
**62 Boulevard Victor-Hugo**
**F-92200 Neuilly-sur-Seine (FR)**

(72) Inventeur : **Gliozzo, Marc**
**31 rue Ravon**
**F-92340 Bourg La Reine (FR)**

(74) Mandataire : **Durand, Yves Armand Louis et al**
**Cabinet Z. Weinstein 20, Avenue de Friedland**
**F-75008 Paris (FR)**

**EP 0 236 158 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention a pour objet un dispositif électronique de régulation en tension selon le préambule de la revendication principale.

On sait que le dispositif d'allumage est déclenché par une étincelle produite par l'énergie libérée au circuit secondaire du transformateur sous l'effet de l'ouverture du circuit primaire dudit transformateur.

La commande de l'étincelle est réalisée par un équipement électronique lié au transformateur par un transistor. Il s'est avéré que le pic de tension qui est induit au moment de l'étincelle au niveau du primaire du transformateur, est destructif pour ce transistor.

Pour limiter ce pic de tension, les dispositifs connus du type décrit plus haut utilisent un organe d'atténuation résistible imposant la présence d'un amplificateur en courant ou en tension. Or un tel amplificateur produit une rotation de phase. Il faut donc tenir compte des fréquences de coupure de l'amplificateur, ce qui rend le système complexe.

La présente invention a pour objectif un dispositif électronique de régulation en tension, qui permet d'amener l'information tension dans la chaîne de régulation sans atténuation et n'implique aucune rotation de phase. De plus, le dispositif régulateur selon l'invention doit être adapté à la technologie des circuits intégrés bipolaires.

Pour atteindre ce but, le dispositif électronique de régulation en tension selon l'invention comporte les caractéristiques énoncées dans la partie caractérisante de la revendication principale.

L'invention sera mieux comprise et d'autres buts, caractéristiques, détails et avantages de celle-ci apparaîtront plus clairement à la lumière de la description explicative qui va suivre faite en référence à la figure unique annexée donnée uniquement à titre d'exemple non limitatif illustrant un mode de réalisation actuellement préféré d'un régulateur en tension selon l'invention.

La figure unique montre un transformateur I comprenant une bobine au secondaire S et une bobine au primaire P dont une extrémité est reliée à la borne positive d'une batterie et l'autre extrémité est reliée au point A d'entrée du régulateur en tension II.

Le régulateur en tension II est relié au point A par l'intermédiaire d'une résistance d'entrée R2 connectée par sa borne B au régulateur en tension qui comprend un comparateur en courant à gain unité III, connecté par une de ses sorties C à un générateur de courant constant IV, et par l'autre sortie D à un amplificateur de courant V par l'intermédiaire d'un circuit de liaison à seuil, et à la masse par un transistor T4. L'amplificateur de courant V est connecté au point A du primaire P.

Le comparateur en courant à gain unité III comprend deux transistors T5, T6 reliés au point B par leurs émetteurs respectifs et montés symétriquement en rendant leur base commune, leurs collecteurs étant respectivement connectés au point C et au point D. Les bases des transistors T5 et T6 sont reliées au point C. Deux autres transistors du type PNP, T3, T4 et montés symétriquement en ayant leurs bases communes, sont reliés par l'intermédiaire de leurs émetteurs respectivement au point C et au point D. Le transistor T3 assure la liaison entre le générateur de courant IV par la sortie collecteur, et le transistor T5. De plus, le collecteur du transistor T3 est relié à la base commune des transistors T3 et T4.

Le générateur de courant est alimenté par une source de tension U1, par l'intermédiaire d'une résistance d'entrée R1, et comprend deux transistors de type NPN T1, T2. La résistance d'entrée R1 est reliée par une de ses extrémités à la fois au collecteur et à la base du transistor T1 et à la base du transistor T2. Chacun des émetteurs des transistors T1 et T2 est relié directement à la masse. Le collecteur du transistor T2 est relié au collecteur du transistor T3. Le circuit à seuil formant la liaison entre le comparateur en courant III et l'amplificateur en courant V comprend une diode D1 formée par un transistor monté en diode ayant son collecteur et sa base reliés au point D et son émetteur relié à la base d'un transistor T7 monté en émetteur suiveur. Son collecteur est relié à une source de tension U2.

Une résistance R4 relie l'émetteur du transistor T7 à l'entrée de l'amplificateur de courant V formé par un étage Darlington T8 de deux transistors.

L'émetteur de l'étage Darlington est relié au moyen de son émetteur à la masse par une résistance R5 et par son collecteur au point A constituant une borne de la bobine du primaire P.

Le régulateur en tension selon la présente invention fonctionne de la façon suivante :

Un courant 2i est dévié dans la résistance R2 et est amené au point B dans le comparateur en courant III avec une valeur i dans chacun des émetteurs des transistors T5, 56.

Le courant 2i a pour équation :

$$2i = \frac{VA - VB}{R2} \quad \text{donc} \quad i = \frac{VA - VB}{2R2}$$

où VA, VB sont les potentiels respectifs des points A, B.

Le courant i passe du transistor T5 au point C puis vers le transistor T3. A l'état ne nécessitant pas de régulation, la diode D1 n'est pas passante. Donc, le courant i circulant dans le transistor T6 passe totalement dans l'émetteur du transistor T4.

Le transistor T2 formant générateur de courant travaille en régime de saturation, c'est-à-dire que sa tension au collecteur est sensiblement 0 volts.

Le transistor T2 reçoit un courant d'entrée iC déterminé par l'équation :

$$iC = \frac{U1 - V_{be}T1}{R1}$$

Avec $V_{be}T1$ = tension base – émetteur du transistor T1 ;

U1 = la source de tension alimentant le générateur en courant IV.

Si la tension au point A augmente, le courant 2i dans les transistors T5 et T6 ou encore i dans le transistor T5 puis le transistor T3 devient légèrement supérieur à la valeur du courant critique iC pour lequel le transistor T2 passe du régime de saturation au régime de limitation où le potentiel au collecteur du transistor T2 devient supérieur à 0 volt. On constate que le courant critique peut être déterminé par la résistance R1. Ainsi, les potentiels aux points C puis B augmentent ainsi que la tension au point D, qui devient alors supérieure ou égale à la tension de seuil de la diode et la diode devient conductrice. La tension le seuil peut être égale à 3 volts.

Ainsi, un courant iD va attaquer la base du transistor T7, et un courant parvient à l'amplificateur en courant V, puis tend à diminuer la tension au point A.

La solution retenue ne comporte pas d'amplificateur en tension, donc n'entraîne pas de rotation de phase. Le courant dévié par la résistance R2 est amené dans un comparateur en courant à gain unité par un émetteur de transistor T5, T6 donc sans amplification et rotation de phase en courant autre que celles introduites par les transistors T7 et T8 pour boucler la chaîne de régulation.

On constate que dans la plage de régulation, le courant 2i dans la résistance R2 est constante, les variations en tension des points A, B sont en phase et amplitude identiques.

La tension au point A est constante, en variation près du point B nécessaire à la régulation, à la précision près des éléments extérieurs au circuit intégré : les résistances R1, R2 et à l'appariement des éléments internes.

A titre d'exemple, les sources de tension U1, U2 délivrent une tension de 5 volts, la résistance R1 a une valeur de 3 K Ω, R2 une valeur de 80 K Ω, R4 une valeur de 15 Ω, et la résistance R5 est du type BUV 37 THOMSON. Avec de telles valeurs et un potentiel, par exemple de 404 volts au point A et de 4 volts au point B, le montage permet d'obtenir une précision globale meilleure que 5%.

## Revendications

1. Dispositif électronique de régulation en tension, limitant le pic de tension, tel que celui fourni au primaire d'un transformateur notamment d'un dispositif d'allumage à commande électronique en particulier de moteur à combustion interne du type comportant une prise d'information tension à une chaîne de régulation comprenant un comparateur et un amplificateur de courant, caractérisé en ce que la prise d'information tension formée par la sortie (A) de l'enroulement primaire est reliée à l'amplificateur de courant (V) et, par une résistance (R2), à une entrée (B) d'un comparateur de courant (III) ayant deux bornes de sortie (C, D) reliées respectivement à un générateur de courant constant (IV) et audit amplificateur de courant (V), par l'intermédiaire d'un circuit de liaison à seuil (D1, T7), que le comparateur de courant (III) est à gain unité et est réalisé sous forme d'un montage à transistors ayant deux transistors (T5, T6) qui sont reliés par leurs bases et connectés par leurs émetteurs à ladite borne d'entrée (B) et dont les circuits collecteurs comportent lesdites bornes de sortie (C, D) et en ce que le générateur de courant comprend un transistor (T2) fonctionnant en régime de limitation ou de saturation selon que le potentiel à la borne de sortie (A) de la primaire du transformateur est supérieure ou non à une valeur prédéterminée et en ce que le circuit de liaison à seuil est adapté pour être bloqué ou passant en fonction du régime de saturation ou de limitation du transistor (T2) du générateur de courant (IV).

2. Dispositif selon la revendication 1, caractérisé en ce que le circuit à seuil comprend une diode (D1).

3. Dispositif selon l'une des revendications précédentes, caractérisé en ce que dans le circuit collecteur des transistors (T5, T6) sont montés respectivement les trajets émetteurs/collecteurs des transistors (T3 et T4) dont les bases sont réunies, que les collecteurs des transistors (T3 et T4) sont respectivement reliés à la masse par l'intermédiaire du transistor (T2) et directement et en ce que l'entrée du circuit à seuil précité est relié à la

jonction du collecteur du transistor (T6) et de l'émetteur des transistors (T4) de façon que le passage du régime de saturation en régime de limitation du transistor (T2) rend passant ledit circuit à seuil.

4. Dispositif selon l'une quelconque des revendications précédentes, caractérisé en ce qu'au transistor (T2) formant générateur de courant est associé un circuit de commande du courant formé par un transistor (T1) dont le collecteur est relié par une résistance (R1) à une source de tension (U1) et dont l'émetteur est relié à la masse, tandis que sa base est reliée à son collecteur et à la base du transistor (T2), la variation du courant du transistor (T2) et le passage des régimes de fonctionnement du transistor (T2) étant réalisés par variation de la résistance (R1).

5. Dispositif selon l'une quelconque des revendications précédentes, caractérisé en ce que la sortie de l'amplificateur de courant (V) avantageusement formé par un étage Darlington, est reliée à la borne de sortie (A) de l'enroulement primaire (P) de façon à maintenir constant le potentiel de cette borne (A) lorsqu'un pic de tension survient entraînant le déclenchement du circuit à seuil.

## Ansprüche

1. Elektronische Spannungsregelnde Vorrichtung zur Begrenzung der Spannungsspitze, wie diejenige, die der Primärwindung eines Transformators insbesondere einer Zündvorrichtung mit elektronischer Steuerung, insbesondere einer Brennkraftmaschine zugeführt wird, derjenigen Gattung, die eine Spannungsangabeentnahme an einer, einen Stromvergleicher und einen Stromverstärker aufweisenden, Reglerkette umfasst, dadurch gekennzeichnet, dass die, durch den Ausgang (A) der Primärwindung gebildete, Spannungsangabeentnahme mit dem Stromverstärker (V) und über einen Widerstand (R2) mit einem Eingang (B) eines Stromvergleichers (III) verbunden ist, der zwei, jeweils mit einem Konstantstromerzeuger (IV) und mit dem besagten Stromverstärke (V) über eine Verbindungsschwellenschaltung (D1, T7) verbundene,Ausgangsklemmen (C, D) hat, dass der Stromvergleicher (III) einen Einheitsgewinn aufweist und als eine Transistorschaltung hergestellt ist, mit zwei Transistoren (T5, T6), die durch ihre Basen verbunden und mit ihren Emittern an die besagte Eingangsklemme (B) angeschlossen sind und deren Kollektorschaltungen die besagten Ausgangsklemmen (C, D) aufweisen und dass der Stromerzeuger einen Transistor (T2) aufweist, der im Begrenzungsbetrieb oder im Sättigungsbetrieb arbeitet, je nachdem das Potential an der Ausgangsklemme (A) der Primärwindung des Transformators grösser oder nicht grösser ist als ein vorbestimmter Wert und dass die Verbindungsschwellenschaltung angepasst ist, um in Abhängigkeit des Sättigungs- oder Begrenzungsbetrie des Transistors (T2) des Stromerzeugers (IV) gesperrt oder leitend zu sein.

2. Vorrichtung nach Anspruch 1, dadurch gekennzeichnet dass die Schwellenschaltung eine Diode (D1) aufweist.

3. Vorrichtung nach einem der vorangehenden Ansprüche, dadurch gekennzeichnet, dass in die Kollektorschaltung der Transistoren (T5, T6) jeweils die Emitter/Kollektorwege der Transistoren (T3 und T4) angeordnet sind, deren Basen zusammengefügt sind, dass die Kollektore der Transistoren (T3 und T4) jeweils über den Transistor (T2) und unmittelbar an die Erdungsmasse angeschlossen sind und dass der Eingang der vorgenannten Schwellenschaltung mit dem Anschluss des Kollektors des Transistors (T6) und des Emitters des Transistors (T4) verbunden ist, so dass der Uebergang von dem Sättigungsbetrieb auf den Begrenzungsbetrieb des Transistors (T2) die besagte Schwellenschaltung leitend macht.

4. Vorrichtung nach irgendeinem der vorangehenden Ansprüche, dadurch gekennzeichnet, dass dem,den Stromerzeuger bildenden, Transistor (T2) eine Stromsteuerschaltung zugeordnet ist, die durch einen Transistor (T1) dessen Kollektor über einen Widerstand (R1) mit einer Spannungsquelle (U1) verbunden und dessen Emitter an Masse angeschlossen ist, gebildet wird, während ihre Basis mit ihrem Kollektor und mit der Basis des Transistors (T2) verbunden ist, wobei die Veränderung des Stromes des Transistors (T2) und der Uebergang zwischen den Betriebsarten des Transistors (T2) durch Aenderung des Widerstandes (R1) bewirkt wird.

5. Vorrichtung nach irgendeinem der vorangehenden Ansprüche, dadurch gekennzeichnet, dass der Ausgang des, in vorteilhafterweise durch eine Darlingtonstufe gebildeten, Stromverstärkers (V) mit der Ausgangsklemme (A) der Primärwindung (P) verbunden ist, um das Potential dieser Klemme (A) konstant zu halten, wenn eine, die Auslösung der Schwellenschaltung veranlassende, Spannungsspitze eintretet.

## Claims

1. Electronic voltage regulation device limiting the voltage peak such as the one supplied to the primary winding of a transformer in partirular of an electronically controlled ignition device in particular of an internal combustion engine, of the type comprising a voltage data tap from a control line comprising a comparator and

a current amplifier, characterized in that the voltage data tap formed of the output (A) of the primary winding is connected to the current amplifier (V) and through a resistor (R2) to an input (B) of a current comparator (III) having two output terminals (C, D) connected to a constant current generator (IV) and to the said current amplifier (V), respectively, through the medium of a connecting threshold circuit (D1, T7), in that the current comparator (III) has a unity gain and is made as a circuitry with transistors having two transistors (T5, T6) which are connected by their bases and connected by their emitters to the said input terminal (B) and the collector circuits of which comprise the said output terminals (C, D) and in that the current generator comprises a transistor (T2) operating in a limitation or saturation mode according as the potential at the output terminal (A) of the primary winding of the transformer is or is not greater than a predetermined value and in that the connecting threshold circuit is adapted to be off or on in accordance with the saturation or limitation operating mode of the transistor (T2) of the current generator (IV).

2. Device according to claim 1, characterized in that the threshold circuit comprises a diode (D1).

3. Device according to one of the preceding claims, characterized in that in the collector circuit of the transistors (T5, T6) are mounted the emitters/collectors paths of the transistors (T3 and T4), respectively, the bases of which are joined together, in that the collectors of the transistors (T3 and T4) are connected through the medium of the transistor (T2) and directly, respectively, to the ground and in that the input of the aforesaid threshold circuit is connected to the junction of the collector of the transistor (T6) and of the emitter of the transistors (T4) so that the change from the saturation mode to the limitation mode of the transistor (T2) makes the said threshold circuit conducting.

4. Device according to any one of the preceding claims, characterized in that with the transistor (T2) forming the current generator is associated a current control circuit formed of a transistor (T1) the collector of which is connected through a resistor (T1) to a voltage source (U1) and the emetter of which is connected to the ground whereas its base is connected to its collector and to the base of the transistor (T2), the variation in current of the transistor (T2) and the change in the operating modes of the transistor (T2) being performed through the variation in the resistor (R1).

5. Device according to any one of the foregoing claims, characterized in that the output of the current amplifier (V) advantageously formed of a Darlington stage is connected to the output terminal (A) of the primary winding (P) so as to keep the potential at this terminal (A) constant when a voltage peak occurs resulting in the triggering of the threshold circuit.

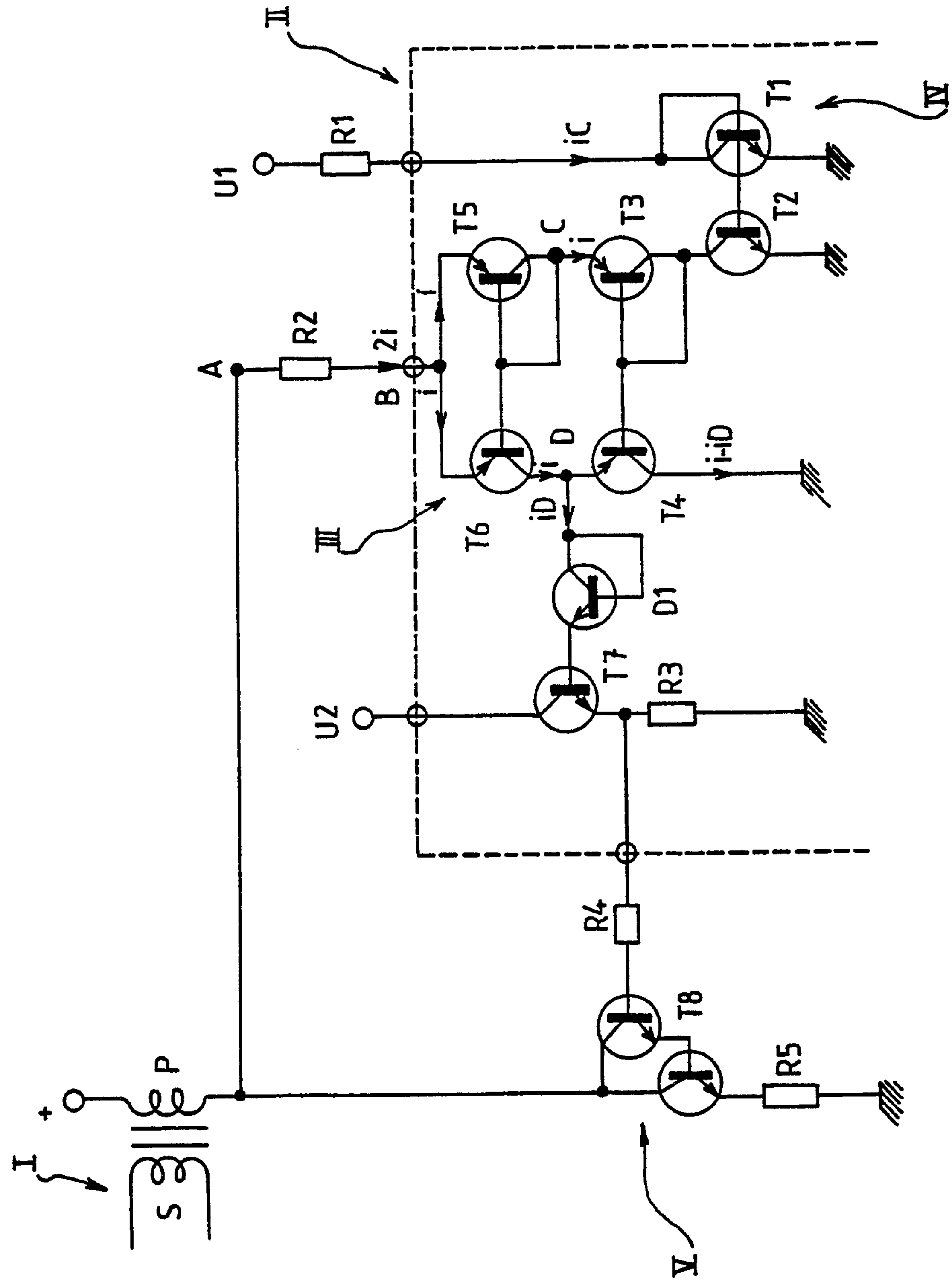
U1
R1
iC
T1
T2
T3
T5
C
i
R2
2i
A
B
D
T6
T4
i-iD
iD
D1
T7
R3
U2
R4
T8
R5
P
S
+
I
II
III
IV
V